(19) **Europäisches Patentamt**
**European Patent Office**
**Office européen des brevets**

(11) **EP 4 550 982 B1**

(12) # FASCICULE DE BREVET EUROPEEN

(45) Date de publication et mention
de la délivrance du brevet:
**05.08.2026 Bulletin 2026/32**

(21) Numéro de dépôt: **24209850.7**

(22) Date de dépôt: **30.10.2024**

(51) Classification Internationale des Brevets (IPC):
***H10F 19/90*** *(2025.01)*

(52) Classification Coopérative des Brevets (CPC):
**H10F 19/902;** Y02E 10/50

(54) **ENSEMBLE POUR MODULE PHOTOVOLTAÏQUE À QUANTITÉ DE COLLE ÉLECTRIQUEMENT CONDUCTRICE OPTIMISÉE**

ANORDNUNG FÜR EIN PHOTOVOLTAISCHES MODUL MIT OPTIMIERTER ELEKTRISCH LEITENDER KLEBSTOFFMENGE

ASSEMBLY FOR A PHOTOVOLTAIC MODULE WITH AN OPTIMISED AMOUNT OF ELECTRICALLY CONDUCTIVE ADHESIVE

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **02.11.2023 FR 2311943**

(43) Date de publication de la demande:
**07.05.2025 Bulletin 2025/19**

(73) Titulaires:
- **Commissariat à l'Energie Atomique et aux Energies Alternatives**
  **75015 Paris (FR)**
- **3SUN S.R.L.**
  **95121 Catania (IT)**

(72) Inventeurs:
- **SOULAS, Romain**
  **38054 GRENOBLE CEDEX 09 (FR)**
- **BARTH, Vincent**
  **38054 GRENOBLE CEDEX 09 (FR)**

- **LUCAS, Corentin**
  **38054 Grenoble cedex 09 (FR)**
- **RAGONESI, Antonino**
  **95016 CATANIA (IT)**
- **CARBONE, Lorenzo**
  **00124 ROME (IT)**

(74) Mandataire: **Santarelli**
**Tour Trinity**
**1 bis Place de la Défense**
**92400 Courbevoie (FR)**

(56) Documents cités:
**US-A1- 2016 064 587**

- **C KAISER: "Reduction of ECA Amount for the Ribbon Interconnection of Heterojunction Solar Cells", 7 September 2020 (2020-09-07), pages 1 - 5, XP093162277, Retrieved from the Internet <URL:https://www.ise.fraunhofer.de/content/ dam/ise/de/documents/publications/ conference-paper/37th-eupvsec-2020/ Kaiser_4AV26.pdf> [retrieved on 20240517], DOI: 10.4229/EUPVSEC20202020-4AV.2.6**

EP 4 550 982 B1

**Description**

**DOMAINE TECHNIQUE**

L'invention se rapporte au domaine des modules photovoltaïques, qui comportent un ensemble de cellules photovoltaïques reliées entre elles électriquement, et plus précisément, sur l'interconnexion des cellules photovoltaïques.

L'invention peut être mise en œuvre pour de nombreuses applications, notamment civiles et/ou militaires, par exemple des applications autonomes et/ou embarquées. Elle peut ainsi notamment être appliquée pour des bâtiments tels que des habitats ou locaux industriels (tertiaires, commerciaux...), par exemple pour la réalisation de leurs toitures, pour la conception de mobilier urbain, par exemple pour de l'éclairage public, la signalisation routière ou encore la recharge de voitures électriques, voire également être utilisée pour des applications nomades (mobilité solaire), en particulier pour une intégration sur des véhicules, tels que voitures, bus ou bateaux, des drones, des ballons dirigeables, entre autres.

**ÉTAT DE LA TECHNIQUE ANTÉRIEURE**

Un module photovoltaïque est formé de chaînes ou encore chapelets, plus communément appelées « *string* », qui sont un assemblage de plusieurs cellules photovoltaïques connectées en série et/ou en parallèle par des rubans d'interconnexion, par exemple des rubans de cuivre étamé.

Le ruban d'interconnexion peut être raccordé électriquement et mécaniquement à une cellule photovoltaïque par soudage ou par collage avec une colle électriquement conductrice (ou ECA pour « *Electrically Conductive Adhesive* » en anglais).

L'utilisation d'une colle électriquement conductrice est préférée du fait de la sensibilité élevée des cellules photovoltaïques, notamment les cellules à hétérojonction, à la température. En effet, la température de polymérisation de la colle électriquement conductrice, est particulièrement faible, par exemple de l'ordre de 160°C à 180°C. Elle est ainsi inférieure à la température mise en œuvre lors du soudage, qui peut être de l'ordre de 260°C à 280°C.

La colle électriquement conductrice comprend des particules conductrices, typiquement des particules d'argent. De ce fait, son utilisation est consommatrice d'argent, dont les ressources sont limitées, et est relativement coûteuse.

Plusieurs solutions connues proposent ainsi de réduire la consommation de colle électriquement conductrice pour le raccordement électrique et mécanique d'un ruban d'interconnexion à une cellule photovoltaïque.

Ces solutions proposent de déposer la colle sous la forme d'une ligne droite continue ou en pointillés, comme le montre notamment l'article de Kaiser et al. intitulé Reduction of ECA amount for the ribbon interconnecion of heterojunction solar cells, 37th European PV Solar Energy Conference and Exhibition, 7-11 September 2020, dont les dimensions (largeur, longueur) sont proches de celles du ruban d'interconnexion.

Ces solutions nécessitent que la ligne de colle et le ruban d'interconnexion soient parfaitement alignés pour obtenir une surface de contact maximale et assurer une adhésion satisfaisante du ruban d'interconnexion sur la cellule photovoltaïque.

Cependant, le dépôt de la colle électriquement conductrice et/ou du ruban d'interconnexion peut être associé à une incertitude de positionnement, qui est notamment liée à la précision de l'équipement utilisé pour le dépôt. Dans les solutions décrites, une telle incertitude peut alors conduire à un désalignement de la colle et du ruban d'interconnexion, et peut ainsi réduire l'adhésion du ruban d'interconnexion sur la cellule photovoltaïque. US 2016/064587 A1 se rapporte à un ensemble comprenant une cellule photovoltaïque avec un ruban d'interconnexion et une ligne de colle, réalisée en un matériau électriquement conducteur, disposée entre la grille de collecte et le ruban d'interconnexion, la colle étant disposée selon un motif en zigzag

**EXPOSÉ DE L'INVENTION**

L'invention a pour objectif de remédier au moins en partie aux inconvénients de l'art antérieur, et plus particulièrement de proposer une solution pour améliorer l'adhérence d'un ruban d'interconnexion sur une cellule photovoltaïque, notamment lorsque le ruban d'interconnexion et la ligne de colle sont désalignés, tout en limitant la consommation de colle électriquement conductrice.

Pour cela, l'objet de l'invention est un ensemble comprenant :

    o au moins une cellule photovoltaïque comprenant une face sur laquelle est ménagée une grille de collecte,
    o au moins un ruban d'interconnexion fixé sur ladite face, ledit ruban d'interconnexion étant destiné à raccorder électriquement et mécaniquement la cellule photovoltaïque à une autre cellule photovoltaïque, et
    o au moins une ligne de colle, réalisée en un matériau électriquement conducteur, disposée entre la grille de collecte et le ruban d'interconnexion, la ligne de colle étant adaptée pour raccorder mécaniquement et électriquement le ruban d'interconnexion à la cellule photovoltaïque, la ligne de colle s'étendant sensiblement selon un axe longitudinal principal et présentant une largeur sensiblement constante.

Selon l'invention, la ligne de colle est disposée selon un motif en zigzag formé d'une pluralité de segments formant chacun un angle inférieur ou égal à 30° avec l'axe longitudinal principal, et avec une amplitude de variation, suivant un axe transversal perpendiculaire à l'axe longitudinal principal, qui est supérieure à la largeur de la ligne de colle.

Certains aspects préférés mais non limitatifs de cet ensemble sont les suivants.

L'angle formé par les segments avec l'axe longitudinal principal peut être compris entre 15° et 30°.

Un rapport entre l'amplitude de variation de la ligne de colle et une largeur du ruban d'interconnexion peut être comprise entre 0.5 et 1.5.

La largeur du ruban d'interconnexion peut être comprise entre 0.2 mm et 1.2 mm.

La ligne de colle électriquement conductrice peut être réalisée en un matériau choisi parmi des colles comprenant des particules conductrices, par exemple des particules d'argent et/ou de cuivre, des nanotubes de carbone ou des nanofils d'argent, ou une matrice polymère, par exemple de type acrylate, époxy ou silicone.

## BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :

La figure 1 représente de manière schématique et partielle, selon une vue de dessus, un ensemble selon un mode de réalisation de l'invention, comportant une cellule photovoltaïque, des rubans d'interconnexion et des lignes de colle électriquement conductrice disposées entre la cellule photovoltaïque et un élément d'interconnexion respectif ;

la figure 2 montre une des lignes de colle électriquement conductrice de la figure 1 prise de manière isolée ;

les figures 3A et 3B montrent un ruban d'interconnexion disposé sur une ligne de colle sans désalignement, avec une ligne de colle droite et fine (fig.3A) et avec une ligne de colle similaire à celle de la figure 2 (fig.3B) ;

les figures 4A et 4B montrent un ruban d'interconnexion disposé sur une ligne de colle avec un désalignement, avec la ligne de colle droite et fine (fig.4A) et avec une ligne de colle similaire à celle de la figure 2 (fig.4B) ;

les figures 5A et 5B montrent un ruban d'interconnexion disposé sur une ligne de colle sans désalignement, avec une ligne de colle droite et large (fig.5A) et avec une ligne de colle similaire à celle de la figure 2 (fig.5B) ; et

les figures 6A et 6B montrent un ruban d'interconnexion disposé sur une ligne de colle avec un désalignement, avec la ligne de colle droite et large (fig.6A) et avec une ligne de colle similaire à celle de la figure 2 (fig.6B).

## EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

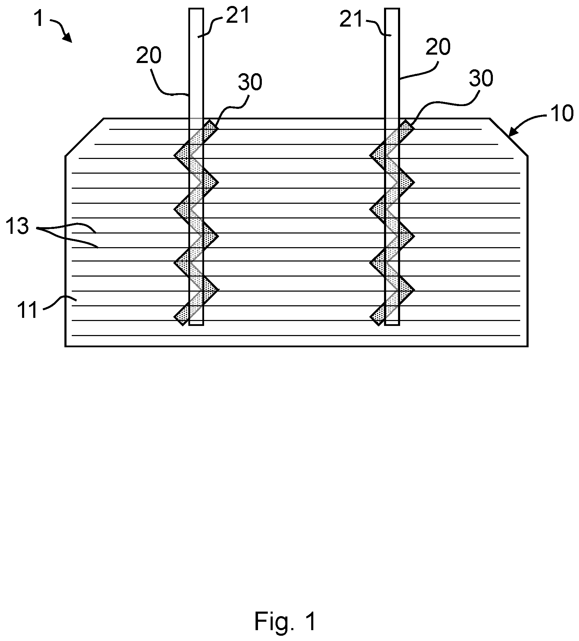

La figure 1 représente de manière schématique et partielle, en vue de dessus un ensemble 1 selon un mode de réalisation de l'invention.

D'une manière générale, un tel ensemble 1 comprend :

o une cellule photovoltaïque 10,
o un ou plusieurs rubans d'interconnexion 20 destinés à raccorder électriquement et mécaniquement la cellule photovoltaïque 10 à une autre cellule photovoltaïque en vue de former une chaîne de cellules photovoltaïques, et
o une ou plusieurs lignes de colle électriquement conductrice 30 raccordant électriquement et mécaniquement chacune un ruban d'interconnexion 20 sur la cellule photovoltaïque 10.

L'ensemble 1 selon l'invention est ainsi destiné à être raccordé électriquement et mécaniquement à une cellule photovoltaïque, par le biais d'un ou plusieurs rubans d'interconnexion 20, en vue de former une chaîne de cellules photovoltaïques.

La cellule photovoltaïque 10 comprend une forme générale de plaque avec une face avant 11 et une face arrière (non représentée) opposée à la face avant. La cellule photovoltaïque 10 comprend ici sur sa face avant 11 une grille de contact 13 adaptée pour assurer la collecte de charges photogénérées. Bien entendu, la cellule photovoltaïque peut aussi comporter une grille de collecte sur sa face arrière.

La grille de collecte 13 est généralement obtenue par impression par sérigraphie d'une pâte d'argent, de cuivre et/ou d'aluminium ou tout autre type de base sur la face avant 11 de la cellule photovoltaïque 10. La grille de collecte 13 est ici formée d'une succession de lignes de collecte parallèles espacées les unes des autres. Optionnellement, la grille de collecte peut comporter en outre une piste conductrice dite Busbar, disposée de sorte à raccorder électriquement les lignes de contact entre elles. Dans ce cas de figure, la piste conductrice Busbar s'étend de préférence perpendiculairement aux lignes de collecte.

D'une manière générale, le ruban d'interconnexion 20 présente une forme globalement plane et allongée. Il est réalisé en un matériau électriquement conducteur, de préférence en cuivre avec un revêtement d'argent. Il peut être réalisé à partir d'autres matériaux.

Le ruban d'interconnexion 20 est disposé sur la face avant 11 de la cellule photovoltaïque 10 de sorte à être raccordé à plusieurs lignes de collecte, ou bien, dans le cas où la grille de collecte comporte une ligne conductrice Busbar, de sorte à être aligné avec cette dernière. Le ruban présente une longueur, suivant un axe longitudinal, qui peut varier en fonction des dimensions de la cellule photovoltaïque, et une largeur, suivant un axe transversal perpendiculaire à l'axe longitudinal, qui peut être comprise entre 0.2 mm et 1.2 mm.

Le ruban d'interconnexion 20 peut comporter une portion libre 21 qui n'est pas superposée à la cellule photovoltaïque 10. L'intérêt de disposer d'une portion libre 21 du ruban d'interconnexion 20 est de faciliter l'interconnexion des cellules photovoltaïques 20.

Par exemple, la portion libre 21 est comprise dans le même plan que le reste du ruban d'interconnexion 20, lequel est ainsi adapté pour raccorder la face avant 11 de la cellule photovoltaïque 10 à une face, généralement arrière, d'une autre cellule photovoltaïque située dans le même plan que la face avant 11. On parle dans ce cas d'architecture d'interconnexion monolithique. En variante, la portion libre 21 peut être comprise dans un plan distinct que le reste du ruban d'interconnexion, lequel est alors adapté pour raccorder la face avant 11 de la cellule photovoltaïque avec une face, généralement arrière, d'une autre cellule photovoltaïque située dans un plan distinct de la face avant 11. On parle dans ce cas d'architecture d'interconnexion standard.

D'une manière générale, la ligne de colle 30, réalisée en un matériau électriquement conducteur, est disposée entre la face avant 11 de la cellule photovoltaïque 10 et le ruban d'interconnexion 20. Elle s'étend ici de manière à être connectée à plusieurs lignes de collecte 13 de la cellule photovoltaïque, et s'étend de préférence perpendiculairement à ces dernières.

La colle électriquement conductrice peut, par exemple être, choisie parmi des colles comprenant des particules conductrices, par exemple des particules d'argent et/ou de cuivre, des nanotubes de carbone ou des nanofils d'argent, ou encore une matrice polymère, par exemple de type acrylate, époxy ou silicone. La colle électriquement conductrice 30 présente avantageusement une température de réticulation comprise entre 160 et 180°C.

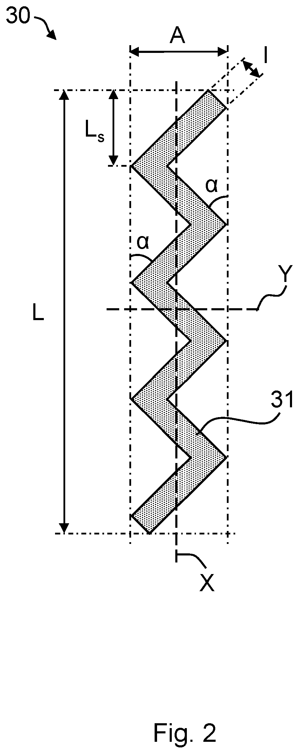

La figure 2 représente la ligne de colle 30 considérée de manière isolée. La ligne de colle 30 présente un axe longitudinal principal X et un axe transversal Y perpendiculaire à l'axe longitudinal principal X.

La ligne de colle 30 est agencée selon un motif en zigzag formé d'une pluralité de segments 31 formant chacun un angle α avec l'axe longitudinal principal X. Par motif ou ligne en zigzag, on entend une ligne brisée formant des angles alternativement saillants et rentrants.

La ligne de colle 30 présente une longueur relative L, définie suivant l'axe longitudinal principal X, et une amplitude A de variation (ou largeur relative) définie suivant l'axe transversal Y. La longueur relative L, ou longueur totale projetée, correspond à la somme de la longueur Ls des segments 31 définie suivant l'axe longitudinal principal X. La longueur Ls, ou longueur élémentaire projetée, correspond à la longueur des segments 31 projetée suivant l'axe X. L'amplitude de variation A correspond à l'écart, suivant l'axe transversal 31, entre les sommets opposés des segments 31. De préférence, l'amplitude A est constante suivant l'axe longitudinal principal X.

La ligne de colle 30 présente une largeur I, correspondant à la largeur des segments 31, sensiblement constante. L'amplitude A de variation de la ligne de colle 30 est supérieure à la largeur I.

La ligne de colle 30 présente ainsi une surface $S_{zz}$, laquelle s'exprime littéralement :

$$S_{zz} = n \times Ls \times l \qquad (1)$$

en notant n le nombre de segments 31, Ls la longueur projetée d'un segment 31, I étant la largeur de la ligne de colle 30.

Cette surface $S_{zz}$ peut également s'exprimer :

$$S_{zz} = \frac{L \times l}{\cos \alpha} \qquad (2)$$

Cette surface $S_{zz}$ tend vers une valeur minimale LxI lorsque l'angle α tend vers zéro (correspondant à une ligne droite et fine), mais qu'elle tend vers une valeur maximale LxA lorsque l'angle tend vers 90° (correspondant à une ligne droite et large).

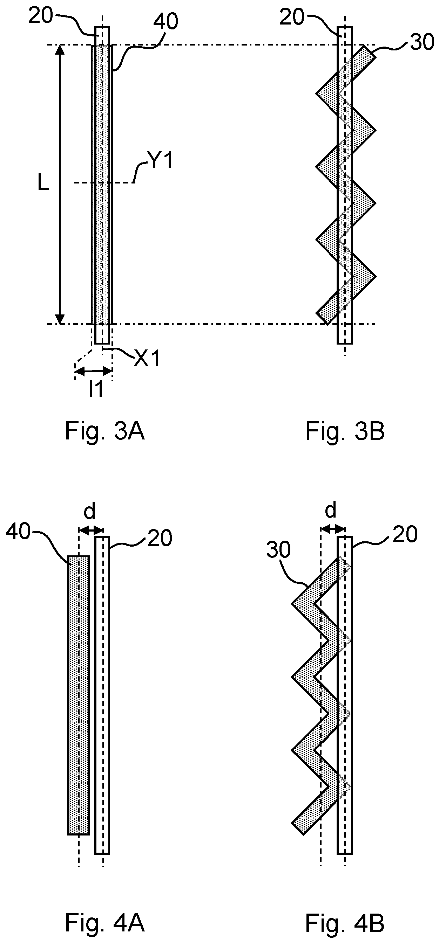

Les figures 3A et 4A montrent un ruban d'interconnexion 20 disposé sur une ligne de colle 40 droite et fine sans désalignement (fig.3A) et avec un désalignement (fig.4A).

La ligne de colle 40 droite et fine présente une longueur L suivant un axe longitudinal X1, et une largeur l1 suivant un axe transversal Y1 perpendiculaire à l'axe longitudinal X1. La largeur l1 de la ligne de colle 40 est ici choisie sensiblement égale à la largeur Ir du ruban d'interconnexion 20 (ici légèrement supérieure). Il convient de noter que la ligne de colle 40 droite et fine correspond à une solution de l'art antérieur précédemment décrite.

En référence à la fig.3A, il apparaît que, lorsque le ruban d'interconnexion 20 et la ligne de colle 40 droite et fine sont alignés, la surface de contact $Sc_1$ entre la ligne de colle 40 et le ruban 20 est maximale : $Sc_{1,max}$ = L×Ir.

En référence à la fig.4A, il apparaît également que, lorsque le ruban d'interconnexion 20 et la ligne de colle 40 droite et fine sont décalés, la surface de contact $Sc_1$ entre la ligne de colle 40 et le ruban d'interconnexion 20 est réduite, voire peut devenir nulle (comme illustré ici). L'adhésion du ruban 20 sur la cellule photovoltaïque est ainsi dégradée. Le décalage latéral correspond ici à un désalignement du ruban 20 vis-à-vis de la ligne de colle 40 suivant l'axe transversal.

Aussi, la surface de contact $Sc_1$ devient nulle lorsque le décalage latéral d entre le ruban d'interconnexion 20 et la ligne de colle 40 atteint un seuil de décalage critique $d_{th}$, correspondant à la somme de la moitié de la largeur Ir du ruban d'interconnexion 20 et de la moitié de la largeur l1 de la ligne de colle 40 : $d_{th}$ = Ir/2 + l1/2.

Les figures 3B et 4B montrent le ruban d'interconnexion disposé sur la ligne de colle 30 en zigzag sans désalignement (fig.3B) et avec un désalignement (fig.4B). Il convient de noter que le désalignement est le même sur les figures 4A et 4B.

Pour faciliter la comparaison avec la ligne de colle 40 droite et fine, on considère que la largeur l de la ligne de colle 30 en zigzag est égale à la largeur ll de la ligne de colle 40 droite et fine. On considère également que la ligne de colle 30 en zigzag et la ligne de colle 40 droite et fine présentent une épaisseur identique.

En référence aux fig. 3A et 3B, il apparaît que, lorsque le ruban d'interconnexion 20 et la ligne de colle 30 en zigzag sont alignés, la surface de contact $Sc_{zz}$ entre la ligne de colle 30 en zigzag et le ruban d'interconnexion 20 est inférieure à la surface de contact $Sc_1$ entre la ligne de colle 40 droite et fine et le ruban d'interconnexion 20.

En référence aux fig. 4A et 4B, il apparaît en revanche que, lorsque le ruban d'interconnexion 20 et la ligne de colle 30 en zigzag sont décalés au-delà du seuil de décalage critique $d_{th}$, la surface de contact $Sc_{zz}$ entre la ligne de colle 30 en zigzag et le ruban d'interconnexion 20 peut être non nulle alors même que la surface de contact $Sc_1$ entre la ligne de colle 40 droite et fine et le ruban d'interconnexion 20 est nulle.

De plus, il apparaît que, à mesure que le désalignement d augmente et dépasse une valeur seuil, la surface de contact $Sc_{zz}$ entre la ligne de colle 30 en zigzag et le ruban d'interconnexion 20 devient supérieure à la surface de contact $Sc_1$ entre la ligne de colle 40 droite et fine et le ruban d'interconnexion 20. En effet, la ligne de colle 30 en zigzag s'étend sur une dimension suivant l'axe transversal Y, à savoir l'amplitude A de variation, qui est supérieure à la dimension suivant l'axe transversal Y1, à savoir la largeur l1, sur laquelle s'étend la ligne de colle 40 droite et fine. De fait, la ligne de colle 30 en zigzag permet d'améliorer l'adhésion du ruban d'interconnexion 20 sur la cellule photovoltaïque en présence d'un désalignement d entre le ruban d'interconnexion et la ligne de colle 30, alors même que, pour un désalignement équivalent, l'adhésion du ruban d'interconnexion 20 via une ligne de colle droite de même largeur peut être dégradée.

La surface S de la ligne de colle 30 en zigzag est toutefois supérieure à une surface S1 de la ligne de colle 40 droite et fine. En effet, la surface de la ligne de colle droite et fine 30, s'exprime littéralement :

$$S1 = L \times l1 \qquad (3)$$

En reprenant l'équation (2), le rapport $\Delta S$ entre la surface S1 de la ligne de colle 40 droite et fine et la surface S de la ligne de colle 30 en zigzag s'écrit :

$$\Delta S = \frac{\frac{L \times l}{\cos \alpha}}{L \times l1} \qquad (4)$$

Lorsque la largeur l de la ligne de colle 30 en zigzag et la largeur l1 de la ligne de colle 40 droite et fine sont égales, on a donc :

$$\Delta S = \frac{1}{\cos \alpha} \qquad (5)$$

Ainsi dans ce cas, le rapport de surface $\Delta S$ (et donc de surconsommation de colle) entre la ligne de colle 30 en zigzag et la ligne de colle 40 droite et fine est uniquement déterminé par l'angle $\alpha$ formé par les segments 31 avec l'axe longitudinal principal X. L'angle $\alpha$ est donc déterminé de sorte à améliorer l'adhésion du ruban sur la cellule photovoltaïque en présence d'un décalage latéral tout en limitant la surconsommation de colle.

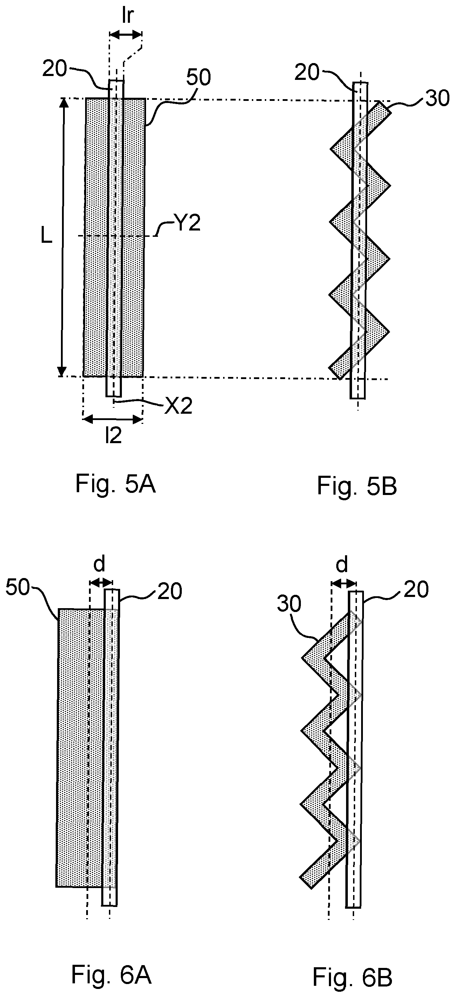

Les figures 5A et 6A montrent un ruban d'interconnexion 20 disposé sur une ligne de colle 40 droite et large sans désalignement (fig.5A) et avec un désalignement (fig.6A).

La ligne de colle 50 droite et large présente une longueur L suivant un axe longitudinal principal X2, et une largeur l2 suivant un axe transversal Y2 perpendiculaire à l'axe longitudinal X2. La largeur l2 de la ligne de colle 50 droite et large est supérieure à la largeur l1 de la ligne de colle 40 droite et fine.

La largeur l2 de la ligne de colle 50 droite et large est telle que, en présence d'un désalignement d2 égal au désalignement d1 des figures 3B et 4B, la surface de contact Sc2 entre la ligne de colle 50 et le ruban d'interconnexion 20 est maximale : $Sc2_{max}$ = L xlr. La largeur l2 est ici égale à trois fois la largeur l1 de la ligne de colle 40 droite et fine.

La ligne de colle 50 droite et large présente ainsi une surface S2 qui est trois fois plus grande que la surface S1 de la ligne de colle 40 droite et fine. Cela représente une consommation de colle additionnelle de 200% pour une même épaisseur.

Les figures 5B et 6B sont similaires aux figures 3B et 4B. Elles permettent d'illustrer la comparaison entre la ligne de colle 30 en zigzag et la ligne de colle 50 droite et large. Pour faciliter cette comparaison, on considère que l'amplitude A de variation de la ligne de colle 30 en zigzag est égale à la largeur l2 de la ligne de colle 50 droite et large. On considère également que la ligne de colle 30 en zigzag et la ligne de colle 50 droite et large présentent une épaisseur identique.

En référence aux fig. 5A à 6B, il apparaît que la surface de contact $Sc_{zz}$ entre la ligne de colle 30 en zigzag et le ruban d'interconnexion 20 est inférieure à la surface de contact Sc2 entre la ligne de colle 50 droite et large et le ruban d'interconnexion 20, avec et sans désalignement.

Il convient de noter, comme indiqué précédemment, que lorsque l'angle $\alpha$ formé par les segments 31 avec l'axe longitudinal principal X tend vers 90°, la surface $S_{zz}$ de la ligne de colle 30 en zigzag tend à se rapprocher de la surface S2 de la ligne de colle 50 droite et large.

Aussi, en augmentant la valeur de l'angle $\alpha$, on améliore l'adhésion du ruban d'interconnexion sur la cellule mais on augmente la consommation de colle. Il a toutefois été constaté que lorsque l'angle $\alpha$ est supérieur à 30°, l'amélioration de l'adhésion n'est pas significative par rapport à l'augmentation de la surconsommation de colle. Autrement dit, il a été constaté qu'une valeur de l'angle $\alpha$ inférieure ou égale à 30° représente un compromis intéressant entre l'adhésion et la surconsommation de colle.

En reprenant l'équation (5), on observe que la consommation additionnelle de colle, par rapport à la ligne droite et fine, lorsque l'angle $\alpha$ est égal à 30° est de 15,5%.

De plus, il a été constaté que lorsque l'angle $\alpha$ est supérieur à 15°, l'adhésion est significativement améliorée. Ainsi, de préférence, l'angle $\alpha$ est compris entre 15° et 30°.

La ligne de colle en zigzag permet, grâce à son amplitude qui est supérieure à sa largeur, d'améliorer l'adhésion du ruban sur la cellule photovoltaïque en cas de désalignement du ruban et de la ligne de colle par rapport à une ligne de colle droite de même largeur. En limitant la valeur de l'angle formé par les segments et l'axe longitudinal principal à 30°, il est possible de limiter la consommation additionnelle de colle à 15,5% par rapport à une ligne de colle droite de même largeur. De plus, cela permet également de réduire la consommation de colle par rapport à une ligne droite et continue ayant une largeur égale à l'amplitude de variation de la ligne de colle en zigzag.

Ainsi, la ligne de colle en zigzag permet d'améliorer l'adhésion du ruban sur la cellule photovoltaïque en cas de désalignement entre le ruban et la ligne de colle, tout en limitant la consommation de colle.

A titre d'exemple, dans le cas d'une ligne de colle droite présentant une longueur relative égale à 100 mm et une largeur égale à 0.3 mm et d'un ruban d'interconnexion présentant largeur égale à 0.6 mm, il apparaît que pour une ligne de colle en zigzag présentant la même longueur relative et la même largeur, une amplitude de 0.5 mm et un angle allant de 5° à 10° permettent une amélioration de la surface de contact pour des décalages importants, par exemple de 0.4 mm, entre le ruban d'interconnexion et la ligne de colle. L'amélioration est de 40% pour un angle de 10° et de 74% pour un angle de 5°. Par ailleurs, l'angle de 10° permet de limiter la surconsommation de colle à 1.5% par rapport à la ligne de colle droite, tandis que l'angle de 5% permet de limiter la surconsommation à 0.4%.

Pour un angle allant de 15° à 30°, il apparaît que la ligne de colle en zigzag permet une amélioration de la surface de contact pour des décalages plus faibles, par exemple de 0.3 mm, entre le ruban d'interconnexion et la ligne de colle. L'amélioration est de 33% pour un angle de 30° lorsque le décalage est de 0.3 mm. L'amélioration est de 20% pour un angle de 15° et de 200% pour un angle de 30° lorsque le décalage est de 0.4mm. Par ailleurs, l'angle de 30° permet de limiter la surconsommation de colle à 15,5% par rapport à la ligne de colle droite, tandis que l'angle de 15% permet de limiter la surconsommation à 3.5%.

A titre d'exemple, la cellule photovoltaïque peut être du type demi M2, c'est-à-dire présentant une forme rectangulaire ayant une longueur environ égale à 78 mm et une largeur environ égale à 156 mm.

Dans ce cas, l'ensemble peut comprendre une pluralité de lignes de colle. Le nombre de lignes peut être compris entre 4 et 20 et de préférence entre 6 et 9. Dans le cas où la grille de collecte comprend une ou plusieurs pistes conductrices, l'ensemble peut comprendre autant de lignes de colle que de pistes conductrices.

Chaque ligne de colle peut par exemple présenter une amplitude comprise entre 0.1 mm et 1.5 mm, une largeur comprise entre 0.1 mm et 1.2 mm, de préférence entre 0.3 mm et 0.8 mm, et une longueur qui est inférieure ou égale à la longueur de la cellule photovoltaïque, qui est ici égale à 78 mm. Le nombre de segments est par exemple compris entre 3 et 21, et plus particulièrement entre 13 et 16.

L'ensemble peut aussi comprendre une pluralité de rubans d'interconnexion. Chaque ruban peut présenter une largeur comprise entre 0.2 mm et 1.2 mm, de préférence entre 0.4 mm et 0.8 mm, et une épaisseur comprise entre 0.1 et 0.4 mm.

Le procédé de fabrication d'un tel ensemble 1 comporte ainsi une étape de réalisation d'une cellule photovoltaïque similaire à celle décrite en référence à la figure 1, et une étape de réalisation d'un ruban d'interconnexion similaire à celui décrit en référence à la figure 1.

Le procédé comporte ensuite une étape de dépôt d'une ligne de colle électriquement conductrice sur une face, par exemple avant et/ou arrière, de la cellule. La ligne de colle est disposée de sorte à intercepter, de préférence perpendiculairement, des lignes de collecte de la cellule. La ligne de colle est déposée de sorte à définir un motif en zigzag formé d'une pluralité de segments formant chacun un angle inférieur à 30° avec l'axe longitudinal principal de la ligne de colle, et présentant une amplitude de variation, suivant l'axe transversal, qui est inférieure à la largeur de la ligne de colle et qui, de préférence, est compris entre 0.5 et 1.5 fois la largeur du ruban d'interconnexion.

Le procédé comporte ensuite une étape de dépôt du ruban d'interconnexion sur la face de la cellule, au contact de la ligne de colle.

On obtient ainsi un ensemble 1 dans lequel l'adhésion du ruban d'interconnexion est améliorée en cas de désalignement du ruban et de la ligne et colle électriquement conductrice, et dans lequel la consommation de colle est limitée.

## Revendications

1. Ensemble comprenant :

   o au moins une cellule photovoltaïque (10) comprenant une face (11) sur laquelle est ménagée une grille de collecte (13),
   o au moins un ruban d'interconnexion (20) fixé sur ladite face (11), ledit ruban d'interconnexion (20) étant destiné à raccorder électriquement et mécaniquement la cellule photovoltaïque (10) à une autre cellule photovoltaïque, et
   o au moins une ligne de colle (30), réalisée en un matériau électriquement conducteur, disposée entre la grille de collecte (13) et le ruban d'interconnexion (20), la ligne de colle (30) étant adaptée pour raccorder mécaniquement et électriquement le ruban d'interconnexion (20) à la cellule photovoltaïque (10), la ligne de colle (30) s'étendant sensiblement selon un axe longitudinal principal (X) et présentant une largeur (I) sensiblement constante,
   o **caractérisé en ce que** la ligne de colle (30) est disposée selon un motif en zigzag formé d'une pluralité de segments (31) formant chacun un angle ($\alpha$) inférieur ou égal à 30° avec l'axe longitudinal principal (X), et avec une amplitude (A) de variation, suivant un axe transversal (Y) perpendiculaire à l'axe longitudinal principal (X), qui est supérieure à la largeur (I) de la ligne de colle (30).

2. Ensemble selon la revendication 1, dans lequel l'angle ($\alpha$) formé par les segments (31) avec l'axe longitudinal principal (X) est compris entre 15° et 30°.

3. Ensemble selon la revendication 1 ou 2, dans lequel un rapport entre l'amplitude (A) de variation de la ligne de colle (30) et une largeur du ruban d'interconnexion (20) est comprise entre 0.5 et 1.5.

4. Ensemble selon la revendication 3, dans lequel la largeur du ruban d'interconnexion (20) est comprise entre 0.2 mm et 1.2 mm.

5. Ensemble selon l'une quelconque des revendications 1 à 4, dans lequel la ligne de colle (30) électriquement conductrice est réalisée en un matériau choisi parmi les colles comprenant des particules conductrices, par exemple des particules d'argent et/ou de cuivre, des nanotubes de carbone ou des nanofils d'argent, ou une matrice polymère, par exemple de type acrylate, époxy ou silicone.

## Patentansprüche

1. Baugruppe, umfassend:

   ◦ mindestens eine Photovoltaikzelle (10), die eine Seite (11) umfasst, an der ein Sammelgitter (13) angebracht ist,
   ◦ mindestens ein an der Seite (11) befestigtes Verbindungsband (20), wobei das Verbindungsband (20) dazu bestimmt ist, die Photovoltaikzelle (10) elektrisch und mechanisch mit einer anderen Photovoltaikzelle zu verbinden, und
   ◦ mindestens eine Klebstoffbahn (30), die aus einem elektrisch leitenden Material hergestellt ist, die zwischen dem Sammelgitter (13) und dem Verbindungsband (20) angeordnet ist, wobei die Klebstoffbahn (30) geeignet ist, das Verbindungsband (20) mechanisch und elektrisch mit der Photovoltaikzelle (10) zu verbinden, wobei sich die Klebstoffbahn (30) im Wesentlichen entlang einer Hauptlängsachse (X) erstreckt und eine im Wesentlichen konstante Breite (I) aufweist,
   ◦ **dadurch gekennzeichnet, dass** die Klebstoffbahn (30) in einem Zickzackmuster angeordnet ist, das aus einer Vielzahl von Segmenten (31) gebildet ist, die jeweils einen Winkel ($\alpha$) kleiner oder gleich 30° zur Hauptlängsachse (X) bilden, und mit einer Variationsamplitude (A) entlang einer Querachse (Y) senkrecht zur Hauptlängsachse (X), die größer ist als die Breite (I) der Klebstoffbahn (30).

2. Baugruppe nach Anspruch 1, wobei der von den Segmenten (31) gebildete Winkel ($\alpha$) mit der Hauptlängsachse (X) zwischen 15° und 30° liegt.

3. Baugruppe nach Anspruch 1 oder 2, wobei ein Verhältnis zwischen der Variationsamplitude (A) der Klebstoffbahn (30) und einer Breite des Verbindungsbands (20) zwischen 0,5 und 1,5 liegt.

4. Baugruppe nach Anspruch 3, wobei die Breite des Verbindungsbands (20) zwischen 0,2 mm und 1,2 mm liegt.

**5.** Baugruppe nach einem der Ansprüche 1 bis 4, wobei die elektrisch leitfähige Klebstoffbahn (30) aus einem Material besteht, das aus Klebstoffen ausgewählt ist, die leitfähige Partikel, beispielsweise Silber- und/oder Kupferpartikel, Kohlenstoffnanoröhren oder Silbernanodrähte, oder eine Polymermatrix, beispielsweise vom Acrylat-, Epoxid oder Silikon, umfasst.

## Claims

**1.** Assembly comprising:

 o at least one photovoltaic cell (10) comprising a face (11) on which a collecting grid (13) is arranged,
 o at least one interconnection strip (20) attached to said face (11), said interconnection strip (20) being intended to electrically and mechanically connect the photovoltaic cell (10) to another photovoltaic cell, and
 o at least one line of adhesive (30), made of an electrically conductive material, disposed between the collecting grid (13) and the interconnection strip (20), the line of adhesive (30) being adapted to mechanically and electrically connect the interconnection strip (20) to the photovoltaic cell (10), the line of adhesive (30) extending substantially along a main longitudinal axis (X) and having a substantially constant width (I),
 o **characterized in that** the line of adhesive (30) is disposed according to a zigzag pattern formed from a plurality of segments (31) each forming an angle ($\alpha$) less than or equal to 30° with the main longitudinal axis (X), and with an amplitude (A) of variation, along a transverse axis (Y) perpendicular to the main longitudinal axis (X), which is greater than the width (I) of the line of adhesive (30).

**2.** Assembly according to claim 1, wherein the angle ($\alpha$) formed by the segments (31) with the main longitudinal axis (X) is between 15° and 30°.

**3.** Assembly according to claim 1 or 2, wherein a ratio between the amplitude (A) of variation of the line of adhesive (30) and a width of the interconnection strip (20) is between 0.5 and 1.5.

**4.** Assembly according to claim 3, wherein the width of the interconnection strip (20) is between 0.2 mm and 1.2 mm.

**5.** Assembly according to any one of claims 1 to 4, wherein the line of electrically conductive adhesive (30) is made of a material chosen from among adhesives comprising conductive particles, for example silver and/or copper particles, carbon nanotubes or silver nanowires, or a polymer matrix, for example of acrylate, epoxy or silicone type.

Fig. 1

Fig. 2

Fig. 3A

Fig. 3B

Fig. 4A

Fig. 4B

Fig. 5A

Fig. 5B

Fig. 6A

Fig. 6B

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2016064587 A1

**Littérature non-brevet citée dans la description**

- **KAISER et al.** Reduction of ECA amount for the ribbon interconnecion of heterojunction solar cells. *37th European PV Solar Energy Conference and Exhibition*, 07 September 2020